Europäisches Patentamt

European Patent Office

Office européen des brevets

(11) Veröffentlichungsnummer: **0 303 126 B1**

## (12) EUROPÄISCHE PATENTSCHRIFT

(45) Veröffentlichungstag der Patentschrift: **29.04.92**

(21) Anmeldenummer: **88112367.3**

(22) Anmeldetag: **29.07.88**

(51) Int. Cl.⁵: **G06F 7/72**, H03M 7/18

(54) **Schaltungsanordnung mit einer zyklisch arbeitenden Zählstufe und einer nachgeschalteten Konverterstufe.**

(30) Priorität: **11.08.87 DE 3726694**

(43) Veröffentlichungstag der Anmeldung:
**15.02.89 Patentblatt 89/07**

(45) Bekanntmachung des Hinweises auf die Patenterteilung:
**29.04.92 Patentblatt 92/18**

(84) Benannte Vertragsstaaten:
**CH DE FR IT LI NL SE**

(56) Entgegenhaltungen:
**FR-A- 2 400 728**
**GB-A- 2 173 022**

(73) Patentinhaber: **SIEMENS AKTIENGESELL-SCHAFT**
**Wittelsbacherplatz 2**
**W-8000 München 2(DE)**

(72) Erfinder: **Wetzel, Friedrich, Dipl.-Ing. (FH)**
**Adelsgasse 31**
**W-8551 Heroldsbach(DE)**
Erfinder: **Nickel, Eckhard, Dipl.-Ing.**
**Franzensbader-Strasse 44**
**W-8552 Höchstadt(DE)**

Rank Xerox (UK) Business Services
(-/2.18/2.0)

## Beschreibung

Die Erfindung bezieht sich auf eine Schaltungsanordnung, bei der entsprechend vorliegenden Eingangssignalen eine zyklisch arbeitende Zählstufe vor- bzw. rückwärtsschaltbar ist, deren absoluter Zählbereich durch eine Breite von n-Stellen eines symmetrischen Binärcods vorgegeben ist, und bei der allen möglichen, entsprechend dem Binärcode unmittelbar aufeinanderfolgenden Ausgangssignalen auch unmittelbar aufeinanderfolgende Stellungen einer nachgeschalteten zyklischen Konverterstufe mit einer Modulozahl m zugeordnet sind.

Derartige Schaltungsanordnungen können beispielsweise zur digitalen Erfassung und Verarbeitung von Winkelpositionen von Rundachsen bei Werkzeugmaschinen oder Robotern benutzt werden. Wenn bei derartigen Schaltungsanordnungen jedoch der Zählbereich kein ganzzahliges Vielfaches der verwendeten Modulozahl ist, führt dies beim Überschreiten des positiven Zählbereiches bzw. beim Unterschreiten des negativen Zählbereiches zu unerwünschten Betriebszuständen der nachgeschalteten Konverterstufe.

Rechenwerke mit Berücksichtigung von Modulozahlen sind aus der GB-A-2173022 bekannt. Dabei ist jedoch kein Zusammenspiel mit zyklischen Konverterstufen vorgesehen.

Aufgabe der Erfindung ist es, eine Schaltungsanordnung der eingangs genannten Art so auszubilden, daß unter allen Bedingungen bei einem Überschreiten des positiven Zählbereiches bzw. einem Unterschreiten des negativen Zählbereiches der Zählstufe ein kontinuierliches Fortschalten der Konverterstufe gewährleistet ist.

Die Aufgabe der Erfindung wird durch die Schaltungsanordnung nach Anspruch 1 gelöst.

Gemäß der Erfindung wird diese Aufgabe dadurch gelöst, daß der Zählstufe ein Umsetzer zugeordnet ist, der bei jedem Überschreiten des positiven Zahlenraumes des absoluten Zählbereiches den unkorrigierten Zählerstand der Zählstufe um den Wert eines Korrektursignals K erhöht und bei jedem Unterschreiten des negativen Zahlenraumes des absoluten Zählbereiches den unkorrigierten Zählerstand der Zählstufe um den Wert des Korrektursignals verringert, wobei der Wert K sich ergibt als:

$$K = 2^n - (INTEGER\ (2^n/m)) \cdot m$$

Vorteilhafte Ausbildungen der Erfindung sind dadurch gekennzeichnet, daß die Zählstufe und der Umsetzer sowie gegebenenfalls auch die Konverterstufe integrale Bestandteile einer Datenverarbeitungsanlage sind. Damit kann das der erfindungsgemäßen Schaltungsanordnung zugrundeliegende Verfahren auch vorteilhaft in üblichen Datenverarbeitungsanlagen zum Einsatz kommen.

Ein Ausführungsbeispiel der Erfindung ist in der Zeichnung dargestellt und wird im folgenden näher erläutert. Dabei zeigen:
FIG 1 ein Blockschaltbild und
FIG 2 eine Zustandstabelle.

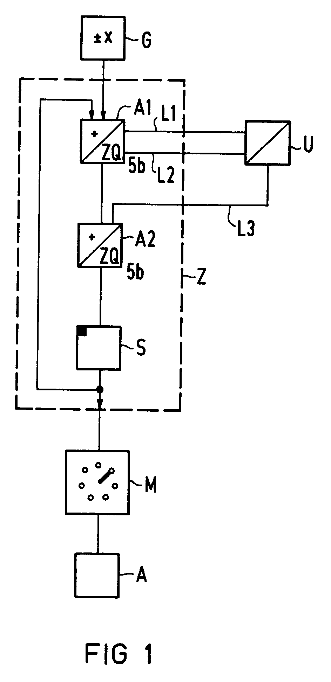

In der Darstellung gemäß FIG 1 ist ein Geber G gezeigt, von dem Eingangssignale +-x ausgelöst werden, die mittels einer Zählstufe Z (gestrichelt angedeutet) in einem Speicher S saldiert werden. Dazu wird zum einen der aktuelle Wert im Speicher S, zum andern das in seiner Größe beliebige Eingangssignal +-x dem Eingang einer ersten Addierstufe A1 zugeführt, die diese Signale miteinander addiert und das Ergebnis an einem Ausgang ZQ in Form eines Binärcodes mit einer Breite von fünf Stellen ausgibt. Die Breite von fünf Stellen ist dabei durch das Symbol 5b angedeutet.

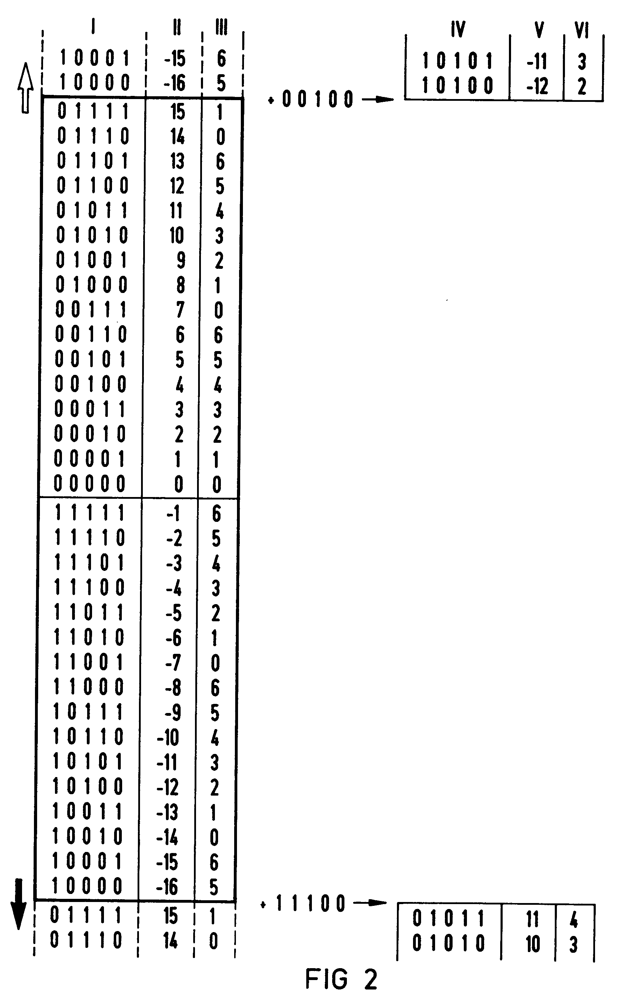

Das Ausgangssignal der Addierstufe A1 gelangt an den Eingang einer gleichartigen Addierstufe A2, deren zweiter Eingang an einen Umsetzer U geschaltet ist. Diesem wird stets dann über eine Leitung L1 von der ersten Addierstufe ein Kennsignal übertragen, wenn eine Binärzahl 01111 überschritten wird, während ein zweites Kennsignal über eine Leitung L2 von der ersten Addierstufe A1 an den Umsetzer U gegeben wird, wenn der negative Zahlenraum unterschritten wird, d.h., wenn die Binärzahl 10000 unterschritten wird. Sofern das erste Kennsignal vorliegt, wird vom Umsetzer U ein Korrektursignal +K, sofern das zweite Kennsignal vorliegt, ein Korrektursignal -K über eine Leitung L3 der zweiten Addierstufe A2 zugeleitet. Als erstes Korrektursignal ergibt sich beim gewählten Ausführungsbeispiel die Binärzahl 00100, als zweites Korrektursignal dient dabei die Binärzahl 11100. Wie es zu eben diesen Korrektursignalen kommt, wird in der Darstellung gemäß FIG 2 noch erläutert. Das Ausgangssignal der zweiten Addierstufe A2 setzt den Speicher S, dessen Ausgangssignal einen Modulo-7-Konverter M ansteuert, dessen mögliche sieben Ausgangssignale beispielsweise in einem nachgeschalteten Anzeigegerät A dargestellt werden können.

In der Darstellung gemäß FIG 2 ist durch eine starke Umrandung der absolute Zählbereich für die Zählstufe Z (FIG.1) angegeben. In einer Spalte I sind dabei für den positiven Zahlenraum die Binärzahlen 00000 bis 01111 aufgeführt, während für den negativen Zahlenraum die Binärzahlen 11111 bis 10000 heranzuziehen sind. Dem positiven Zahlenraum sind dabei, wie in Spalte II angedeutet, die Dezimalzahlen 0 bis 15 zugeordnet, während, wie ebenfalls in Spalte II angedeutet, dem negativen Zahlenraum die Dezimalzahlen -1 bis -16 zugeordnet sind.

In einer Spalte III ist gezeigt, welche Stellungen der Modulo-7-Konverter M (FIG 1) einnimmt, der seine sieben Stellungen 0 bis 6 fortlaufend mit dem Fortschalten der Binärzahlen einnimmt. Im absoluten Zählbereich besteht eine feste Zuordnung zwischen den Binärzahlen und den Stellungen des Modulo-7-Konverters. Eine Erhöhung der Binärzahlen um "1" bewirkt auch ein Fortschalten des Modulo-7-Konverters um "1".

Es sei jedoch nunmehr der Fall angenommen, daß die Zählstufe Z (FIG 1) über ihren positiven Zahlenraum hinaus fortgeschaltet wird. Dies findet seinen Ausdruck in der Darstellung gemäß FIG 2 durch einen offenen Doppelpfeil. Es zeigt sich, daß die der Binärzahl 01111 am Ende des positiven Zahlenraums folgende Binärzahl die Binärzahl 10000 und im weiteren (gestrichelt angedeutet) die Binärzahl 10001 folgt. Die Binärzahl 10000 entspricht im absoluten Zählbereich der Dezimalzahl -16, die Binärzahl 10001 findet ihre Entsprechung in der Dezimalzahl -15. Der Dezimalzahl -16 entspricht wiederum im absoluten Zahlenraum die Stellung 5 des Modulo-7-Konverters; der Dezimalzahl -15 entspricht die Stellung 6 des Modulo-7-Konverters. Ein Fortschalten des Zählerstandes der Zählstufe Z um "1" über die Grenze des positiven Zahlenraums hinaus führt also dazu, daß die Stellung des Modulo 7-Konverters sich um "4" erhöht. Weitere Erhöhungen um jeweils "1" ergeben auch für die Stellung des Modulo-7-Konverters jeweils Erhöhungen um "1".

Dieser Sprung beim Überschreiten des positiven Zahlenraumes kann gemäß der Erfindung jedoch dadurch kompensiert werden, daß immer dann, wenn eine Binärzahl 01111 in positiver Richtung überschritten wird, das im Zusammenhang mit FIG 1 bereits erwähnte Korrektursignal +K generiert wird, wobei sich K als

$$K = 2^n - (\text{INTEGER } (2^n/m)) \cdot m$$

ergibt. (Der Wert K kann dabei allerdings auch um ein beliebiges Vielfaches von m erhöht werden.)

Wie durch einen waagrechten Pfeil im oberen Teil von FIG 2 angedeutet, wird daher beim Überschreiten des positiven Zahlenraumes jede folgende Binärzahl um die Binärzahl 00100 erhöht, was dazu führt, daß an den positiven Zahlenraum sich nunmehr (wie in Spalte IV angedeutet) die Binärzahlen 10100 und 10101 anschließen, die den Dezimalzahlen -12 bzw. -11 entsprechen, welchen wiederum die Stellungen 2 und 3 des Modulo-7-Konverters zugeordnet sind. Ein Springen der Stellung des Modulo-7-Konverters beim Überschreiten des positiven Zählbereiches ist damit vermieden, denn auf die Stellung "1" am Ende des positiven Zählbereiches (siehe Spalte III) folgt die Stellung "2", an die sich die Stellung "3" anschließt, wie dies im oberen Teil von Spalte VI gezeigt ist.

Für das Unterschreiten des negativen Zahlenraums des absoluten Zählbereiches, das durch einen ausgefüllten starken Pfeil angedeutet ist, gilt entsprechendes.

An die Binärzahl 10000, die der Dezimalzahl -16 entspricht, und welcher die Schalterstellung 5 des Modulo-7-Konverters zugeordnet ist, schließen sich, wie gestrichelt angedeutet, die Binärzahlen 01111 und 01110 an, denen die positiven Dezimalzahlen 15 und 14 entsprechen, denen wiederum die Schalterstellungen 1 und 0 des Modulo-7-Konverters zugeordnet sind. Um einen Sprung von der Stellung 5 auf die Stellung 1 des Modulo-7-Konverters am Übergang über den negativen Zahlenbereich zu eliminieren, wird das Korrektursignal K als Binärzahl 11100 zu den auf das Überschreiten des negativen Zahlenbereiches hin folgenden Binärzahlen addiert, was im Ausführungsbeispiel in den Spalten IV, V und VI unten seinen Niederschlag darin findet, daß dort auf die letztmögliche negative Binärzahl 10000 im negativen absoluten Zahlenraum die Binärzahl 01011 und die Binärzahl 01010 folgen, denen die positiven Dezimalzahlen 11 und 10 zugeordnet sind, denen wiederum die Stellungen 4 und 3 des Modulo-7-Konverters entsprechen. Diese letztgenannte Stellung 4 schließt sich nach der Korrektur um -K stetig an die Stellung 5 am Ende des negativen Zahlenraums des absoluten Zählbereiches an.

Im Ausführungsbeispiel ist für die Stellenzahl n ein Wert "5" verwendet worden und die Modulo-Zahl m beträgt "7". Es sind jedoch auch beliebige andere Konstellationen denkbar.

**Patentansprüche**

1. Schaltungsanordnung, bei der entsprechend vorliegenden Eingangssignalen (+-x) eine zyklisch arbeitende Zählstufe (Z) vorbzw. rückwärtsschaltbar ist, deren absoluter Zählbereich durch eine Breite von n-Stellen eines symmetrischen Binärcodes vorgegeben ist, dadurch gekennzeichnet, daß bei der allen moglichen, entsprechend dem Binärcode unmittelbar aufeinanderfolgenden Ausgangssignalen auch unmittelbar aufeinanderfolgende Stellungen einer nachgeschalteten zyklischen Konverterstufe (M) mit einer Modulozahl m zugeordnet sind, und, daß der Zählstufe (Z) ein Umsetzer (U) zugeordnet ist, der bei jedem Überschreiten des positiven Zahlenraumes des absoluten Zählbereiches den unkorrigierten Zählerstand der Zählstufe (Z) um den Wert eines Korrektursignales K erhöht und bei jedem Unterschreiten des negativen Zahlenraumes des absoluten Zählbereiches den unkorrigierten Zählerstand der Zählstufe (Z) um den Wert des Korrektursignals K verringert, wobei der Wert K sich ergibt als:

$$K = 2^n - (\text{INTEGER} (2^n/m)) . m$$

2. Schaltungsanordnung nach Anspruch 1, **dadurch gekennzeichnet,** daß die Zählstufe (Z) und der Umsetzer (U) integrale Bestandteile einer Datenverarbeitungsanlage sind.

3. Schaltungsanordnung nach Anspruch 2, **dadurch gekennzeichnet,** daß die Konverterstufe (M) integraler Bestandteil der Datenverarbeitungsanlage ist.

## Claims

1. Circuit arrangement, wherein a cyclically operating counter stage (Z) can be connected in front of or behind correspondingly present input signals (+-x), the absolute counting range of the counter stage (Z) being specified by a width of n digits of a symmetrical binary code, characterized in that with all possible directly successive output signals corresponding to the binary code there are also associated directly successive positions of a subsequently connected cyclical converter stage (M) with a modulo number m, and in that a converter (U) is associated with the counter stage (Z), which converter (U) with each exceeding of the positive number region of the absolute counting range increases the uncorrected count of the counter stage (Z) by the value of a correction signal K and with each falling-short of the negative number region of the absolute counting range reduces the uncorrected count of the counter stage (Z) by the value of the correction signal K, whereby the value K results as:

$$K = 2^n - (\text{INTEGER} (2^n/m)) . m$$

2. Circuit arrangement according to claim 1, characterized in that the counter stage (Z) and the converter (U) are integral components of a data-processing installation.

3. Circuit arrangement according to claim 2, characterized in that the converter stage (M) is an integral component of the data-processing installation.

## Revendications

1. Montage dans lequel un étage de comptage (Z) opérant de façon cyclique peut effectuer un comptage progressif ou régressif en fonction de signaux d'entrée présents (+-x), étage de comptage dont la gamme de comptage absolue est prédéterminée par une largeur de n chiffres d'un code binaire symétrique, caractérisé par le fait que pour tous les signaux de sortie possibles, qui se succèdent directement conformément au code binaire, également des positions, qui se succèdent directement, d'un étage convertisseur cyclique (M) branché en aval sont associées à un nombre modulo m et qu'à l'étage de comptage (Z) est associé un convertisseur (U), qui, lors de chaque dépassement par valeurs inférieures de la plage de comptage positive de la gamme de comptage absolue, accroît l'état de comptage non corrigé de l'étage de comptage (Z), de la valeur d'un signal de correction K, et, lors de chaque dépassement par valeurs inférieures de la plage de comptage négative de la gamme de comptage absolue, réduit l'état de comptage non corrigé de l'étage de comptage (Z), de la valeur du signal de correction K, la valeur K étant fournie par :

$$K = 2^n - (\text{ENTIER} (2^n/m)) . m$$

2. Montage suivant la revendication 1, caractérisé par le fait que l'étage de comptage (Z) et le convertisseur (U) font partie intégrante d'une installation de traitement de données.

3. Montage suivant la revendication 2, caractérisé par le fait que l'étage convertisseur (M) fait partie intégrante de l'installation de traitement de données.

FIG 1

| I | II | III |
|---|---|---|
| 1 0 0 0 1 | -15 | 6 |
| 1 0 0 0 0 | -16 | 5 |
| 0 1 1 1 1 | 15 | 1 |
| 0 1 1 1 0 | 14 | 0 |
| 0 1 1 0 1 | 13 | 6 |
| 0 1 1 0 0 | 12 | 5 |
| 0 1 0 1 1 | 11 | 4 |
| 0 1 0 1 0 | 10 | 3 |
| 0 1 0 0 1 | 9 | 2 |
| 0 1 0 0 0 | 8 | 1 |
| 0 0 1 1 1 | 7 | 0 |
| 0 0 1 1 0 | 6 | 6 |
| 0 0 1 0 1 | 5 | 5 |
| 0 0 1 0 0 | 4 | 4 |
| 0 0 0 1 1 | 3 | 3 |
| 0 0 0 1 0 | 2 | 2 |
| 0 0 0 0 1 | 1 | 1 |
| 0 0 0 0 0 | 0 | 0 |
| 1 1 1 1 1 | -1 | 6 |
| 1 1 1 1 0 | -2 | 5 |
| 1 1 1 0 1 | -3 | 4 |
| 1 1 1 0 0 | -4 | 3 |
| 1 1 0 1 1 | -5 | 2 |
| 1 1 0 1 0 | -6 | 1 |
| 1 1 0 0 1 | -7 | 0 |
| 1 1 0 0 0 | -8 | 6 |
| 1 0 1 1 1 | -9 | 5 |
| 1 0 1 1 0 | -10 | 4 |
| 1 0 1 0 1 | -11 | 3 |
| 1 0 1 0 0 | -12 | 2 |
| 1 0 0 1 1 | -13 | 1 |
| 1 0 0 1 0 | -14 | 0 |
| 1 0 0 0 1 | -15 | 6 |
| 1 0 0 0 0 | -16 | 5 |
| 0 1 1 1 1 | 15 | 1 |
| 0 1 1 1 0 | 14 | 0 |

+ 0 0 1 0 0 →

| IV | V | VI |
|---|---|---|
| 1 0 1 0 1 | -11 | 3 |
| 1 0 1 0 0 | -12 | 2 |

+ 1 1 1 0 0 →

| IV | V | VI |
|---|---|---|
| 0 1 0 1 1 | 11 | 4 |
| 0 1 0 1 0 | 10 | 3 |

FIG 2